# EUROPEAN PATENT APPLICATION

(11) **EP 4 148 779 A1**
(43) Date of publication of application: **15.03.2023**
(21) Application number: 21196518.1
(22) Date of filing: 14.09.2021
(51) Int. Cl.: H01L 23/495, H01L 23/31

(54) **A SEMICONDUCTOR DEVICE AND A METHOD OF MANUFACTURE**

(71) Applicant: Nexperia B.V., 6534 AB Nijmegen (NL)
(72) Inventor: Yandoc, Ricardo, 6534 AB Nijmegen (NL); Brown, Adam, 6534 AB Nijmegen (NL); Stapelberg, Norman, Nijmegen (NL); Balakrishnan, Manoj, 6534 AB Nijmegen (NL)
(74) Representative: Pjanovic, Ilija

(57) **Abstract**

This disclosure relates to a semiconductor device comprising a leadframe, a die attached to the leadframe using a first solder, a source clip and a gate clip attached to the die using a second solder, and a drain clip attached to the leadframe. The semiconductor device is inverted, so that the source clip and the gate clip are positioned on the bottom side of the semiconductor device, wherein the leadframe is positioned on the top side of the semiconductor device so that the leadframe is a top exposed drain clip. The source clip and/or the drain clip comprise a half cut locking feature. The half cut locking feature can be formed as a wing and located at the sides of the source clip and the gate clip.

## Description

### FIELD

The present invention relates to a semiconductor device. The invention also relates to a method of manufacturing of a semiconductor device.

### BACKGROUND

A known loss free package (LFPAK) semiconductor device is described in US patent US6777800B2. A semiconductor die is mounted to a lead frame with leads. Wires couple the semiconductor die to the leads. The wires, the semiconductor die and then the most of the lead frame are then encapsulated in a molding material. The molding material is then shaped. The formed semiconductor die package includes a molded body that has leads extending laterally away from the molded body. The semiconductor die package is mounted onto a circuit board.

As consumer electronics (e.g., cell phones, laptop computers, etc.) continue to decrease in size, there is an ever increasing demand for thinner electronic devices and thinner electronic components. In addition, the heat dissipation properties of a semiconductor die package should be improved. For example, power semiconductor devices such as vertical MOSFETs (metal oxide field effect transistors) can generate a significant amount of heat. For high output power applications (e.g., more than 60 Watts), special packaging is required to remove heat from the power transistor to prevent overheating. Overheating can also degrade the operational characteristics of a power transistor.

In one embodiment described in the above mentioned patent a semiconductor die package comprises: (a) a semiconductor die comprising a first surface, a second surface, and a vertical power MOSFET having a gate region and a source region at the first surface, and a drain region at the second surface; (b) a drain clip having a major surface and being electrically coupled to the drain region; (c) a gate lead electrically coupled to the gate region; (d) a source lead electrically coupled to the source region; and (e) a non-conductive molding material encapsulating the semiconductor die, wherein the major surface of the drain clip is exposed through the non-conductive molding material.

In another embodiment of the above mentioned patent a semiconductor die package comprises: (a) a semiconductor die comprising a first surface, a second surface, and a vertical power MOSFET having a gate region and a source region at the first surface, and a drain region at the second surface; (b) a drain clip having a major surface and being electrically coupled to the drain region; (c) a drain lead electrically coupled to an end of the drain clip; (d) a gate lead electrically coupled to the gate region; (e) a source lead structure including at least one source lead and a protruding region having a major surface, and a die attach surface opposite the major surface of the source lead structure, the die attach surface being electrically coupled to the source region; and (f) a non-conductive molding material encapsulating the semiconductor die, wherein the major surface of the drain clip is exposed through the non-conductive molding material.

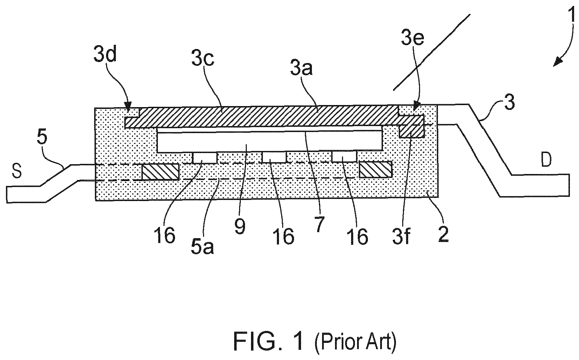

Another known semiconductor device is shown in Figure 1. The device comprises an inverted MOSFET package, with an exposed drain tab on the top of the device with gull wing leads.

Also known in the art are semiconductor packages combining several semiconductor components into a single package so to simplify circuit design, reduce costs, and provide greater efficiency and improved performance by keeping related and dependent circuit components in close proximity. These integrated multi-chip device packages facilitate application integration and greater electrical and thermal performance compared to using discrete components. This trend towards greater circuit integration has resulted in the development and use of the power quad flat no-lead (PQFN) package, which can comprise a multi chip module (MCM) in larger form factors such as 12 mm by 12 mm. By exposing large surface area die pads on the bottom surface of the PQFN package, performance is optimized for high power density circuit applications requiring efficient thermal dissipation.

One of the advantages of the PQFN package is the low cost of fabrication, as a simple low cost leadframe is utilized for the base material rather than expensive multi-layered substrates. However, as a result of this single layer configuration, electrical wiring and routing becomes a particular challenge, particularly for larger and more complex multi chip modules supported by the 12 mm by 12 mm form factor. Package designs directly interconnecting power devices such as power MOSFETs and IGBTs using multilayer substrates are not possible using simple single layer lead frames. Since much of the top surface electrical interconnects must be by wirebonds, wire layouts must be carefully designed to prevent wire shorting. While increasing package thickness may reduce the risks of wire shorting, this is often undesirable for maintaining package reliability as the risk of package cracking may increase.

### SUMMARY

Various example embodiments are directed to the disadvantage as described above and/or others which may become apparent from the following disclosure.

According to an embodiment of this invention a semiconductor device comprises a leadframe, a die attached to the leadframe using a first solder, a source clip and a gate clip attached to the die using a second solder, and a drain clip attached to the leadframe. The semiconductor device is inverted, so that the source clip and the gate clip are positioned on the bottom side of the semiconductor device, wherein the leadframe is positioned on the top side of the semiconductor device so that the leadframe is a top exposed drain clip. The source clip and/or the gate clip comprise a half cut locking feature. The half cut locking feature can be formed as a wing and located at the sides of the source clip and/or the gate clip.

The drain clip can comprise a dual bending. The drain clip is made of copper. The bending angle of the dual bending can be about 90 degrees. The dual bending can be arranged so to prevent any mechanical tilting within the semiconductor device. The dual bending can be arranged so to maintain the same level for all parts of the semiconductor device.

The semiconductor device can be a PQFN semiconductor device, or a HEMT semiconductor device, or a MOSFET semiconductor device.

The semiconductor device can further comprise two cooling systems, a first cooling system positioned on the top side on the semiconductor device and a second cooling system positioned on the bottom side of the semiconductor device.

The present invention also relates to a method of producing a semiconductor device, the method comprising the steps:
- creating a leadframe,
- printing a first solder on the top of the leadframe,
- attaching a die via the first solder to the leadframe,
- creating source, gate and drain clips,
   ∘ wherein the drain clip is bended and attached the respective leadframe, and
   ∘ wherein the source and drain clips are attached to the die,
- providing a molding,
- grinding or polishing so to expose the source, gate and drain terminals,
- singulation,
- inverting the semiconductor device, and
- mounting,
wherein the source clip and the drain clip comprise a half cut locking feature, preferably about 50% of cu material thickness.

The half cut locking feature is formed as a wing and located at the sides of the source clip and/or the gate clip.

An advantage of the semiconductor device described in the previous embodiments is that half cut locking feature significantly improves the robustness of the semiconductor device, since this feature minimizes a risk of package cracking and detachment of Cu from the plastic body during the clip and package saw singulation. The wings anchor the clips in the plastic body.

Furthermore, having a drain clip with a dual bending provides a better control as a spring back return during forming will be avoided, normally brought by reaction of variability of radius applied on the bending.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 shows a known semiconductor device;
Figure 2 illustrates a semiconductor device according to an embodiment of the invention;
Figure 3 illustrates a semiconductor device according to an embodiment of the invention.
Figure 4 illustrates a method of manufacturing of a semiconductor device according to an embodiment of the invention;

### DETAILED DESCRIPTION

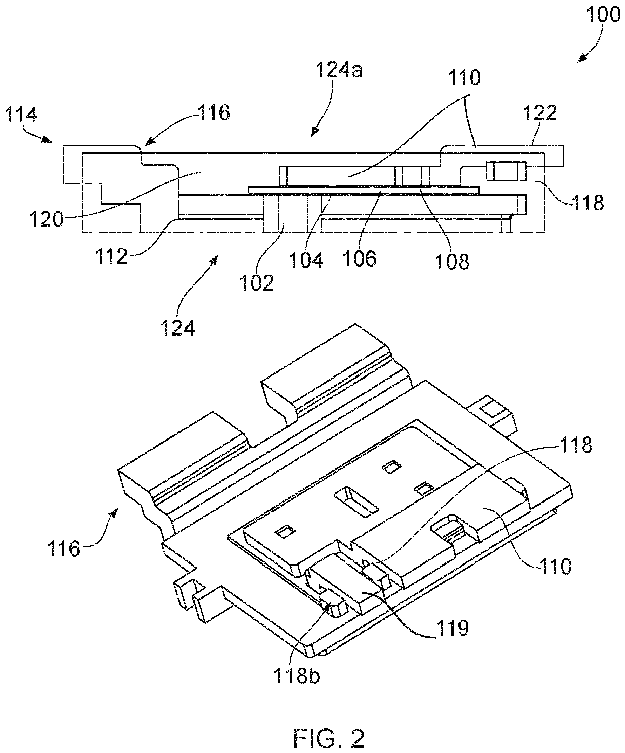

Figure 2 illustrates an embodiment of the present invention. A semiconductor device 100 comprises a leadframe 102, a die 106 attached to the leadframe 102 via a first solder 104, and a source clip 110, and a gate clip 119 attached to the die 106 via a second solder 108.

The semiconductor device 100 further comprises a mold 120, wherein the mold is arranged so that a source 110, gate 119 and a drain 114 of the semiconductor device 100 are partially exposed on a first side 124a of the semiconductor device 100. A partially exposed part of the source clip 110 is marked with the reference number 122. The leadframe 102 is acting as an exposed drain 112 of the semiconductor device, and this exposed drain 112 is on a second side 124 of the semiconductor device.

Such a semiconductor device is inverted, so that the source 110, the gate 119 and the drain 114 are positioned on the bottom of such a semiconductor device 100 and wherein the leadframe 102 is positioned on the top of such semiconductor device 100, which the leadframe 102 is the exposed drain 112.

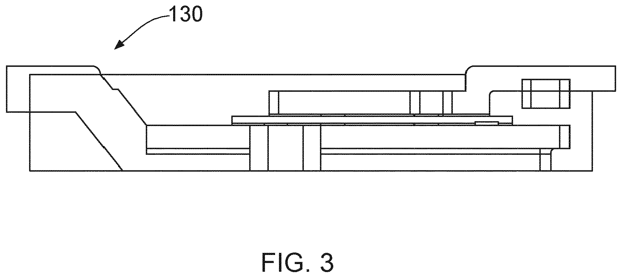

According to an embodiment of the present invention, the leadframe 102 is comprising a dual bending 116, also called a dual step, at the end where the partially exposed drain 114 is located. The drain can be made of copper. Advantage of such a dual bending 116 is that the partially exposed drain 114 will contribute to an uncontrolled coplanarity due to spring back return and inconsistency of leads coplanarity with package surface. This is critical for moulding process. Controlling the coplanarity against the package surface of bended tip of the die paddle is also hard to control due to multiple tolerance to combine such as cutting the exposed lead tip followed by bending. An alternative way of controlling this is by flat leads, i.e. a single step continuous Cu with partially exposed flat leads. This is shown in Figure 3, reference sign 130. The usage of the above described dual step forming is recommended so to form the drain exposed on both top and bottom of the package much easier to manufacture. A dual step forming will have a better control as spring back return during forming will be avoided, normally brought by reaction of variability of radius applied on the bending.

According to an embodiment of the present invention, the source clip 110 and/or gate clip 119 comprise a half cut locking (a half cut locking for source clip is marked with the reference number 118, a half cut locking for gate clip is marked with the reference number 118b), which half cut locking can be preferably about 50% of copper material thickness, and which half cut locking is/are located on the side of the source clip and/or gate clip, formed as a wing. Having such half cut locking 118/118b, significantly improve the reliability of the manufacturing process of such a semiconductor device, since partially exposing source and drain terminals without locking features will result to package crack during clip and package singulation.

Since partial embedding of source and drain terminals will guarantee fillet formations on the lead terminal sides, the effectivity of this also depends on how the clips are locked on the plastic, thus additional half cut feature, formed like a wing, located on the sides of the clips were added. This is to ensure locking that will be stable during clip singulation process.

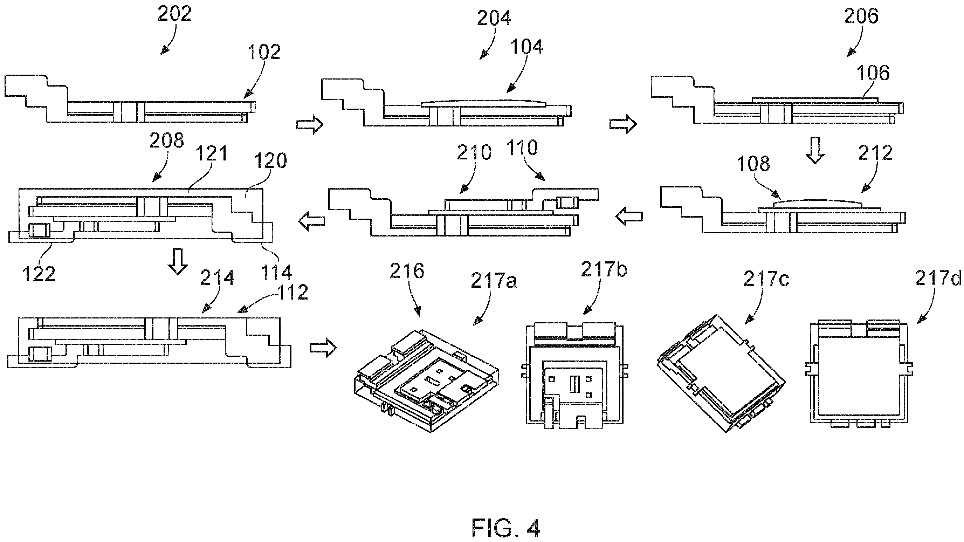

The invention also relates to a method of producing a semiconductor device. The method is shown in Figure 4.

The method comprises the steps:
- creating a leadframe 102, preferably with a dual step bending (reference number 202 in Figure 4),
- a first solder 104 dispensed on the top of the leadframe 102 (reference number 204 in Figure 4),
- attaching a die 106 via the solder 104 to the leadframe 102 (reference number 206 in Figure 4),
- a second solder 108 dispensed on the top of the die 106 (reference number 208 in Figure 4),
- attaching a source clip 110 and a gate clip 119 to the die 106 via a second solder 108 (reference number 210 in Figure 4), wherein the source clip 110 is preferably created with a half cut locking feature 118, preferably formed like wings 118, and/or the gate clip 119 is preferably created with a half cut locking feature 118b, preferably formed like wings 118b,
- providing over molding 120 (reference number 212 in Figure 4), wherein over molded package 121 is created, wherein the molding is arranged so that the source 110 and the drain 114 are partially exposed,
- grinding or polishing so to remove the top molding and to expose the drain terminal 112 (reference number 214 in Figure 4), and
- singulation (reference number 216 in Figure 4).

A semiconductor device created according to above described method is inverted and mounted.

A semiconductor device created by this method is shown in Figure 4, wherein a top view of the semiconductor device marked with the reference numbers 217a and 217b, and wherein a bottom view of the semiconductor device marked with the reference numbers 217c and 217d.

The embodiments of the present invention are applicable for all semiconductor packages/devices using clips as interconnects.

A semiconductor device according to an embodiment of the present invention is especially advantageous for PQFN semiconductor devices used at the automotive markets.

The semiconductor device having the gate and source clips modified under EMC with side protrusions, made by half cut locking features, which are fully encapsulated provide a significantly improved robustness, i.e. a significant mechanical benefit.

A semiconductor discrete package with terminals on one side of the package that are partially embedded inside a plastic encapsulation, locked in the plastic through the use of single or multiple half cut locking features located at the side of the copper, formed like a wing, has advantages over the known semiconductor devices.

Such a semiconductor discrete package with top and bottom drain exposed will not have a problem of an uncontrolled coplanarity and inconsistency of leads coplanarity with package surface. Using dual step bending, as described in the embodiments of the present invention, so to form the drain exposed on both top and bottom of the package will have a better control as spring back return during forming will be avoided, normally brought by reaction of variability of radius applied on the bending.

Therefore the semiconductor package will not suffer of a possible package crack during the clip singulation.

Furthermore, providing partially embedding of the terminals with additional half cut locking feature formed like a wing, located on the sides of the clips, will provide a further advantage. This feature will ensure locking so that the package is stable during clip singulation process.

The semiconductor device according to the embodiments of the present invention can be also used for semiconductor packages with dual exposed heatsink, dual cool packages, microlead packages, all semiconductor packages using a clip as interconnects (integrated to leads or internal clips), power packages using a solder as die attach material, and similar.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalisation thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

Term "comprising" does not exclude other elements or steps, the term "a" or "an" does not exclude a plurality. Reference signs in the claims shall not be construed as limiting the scope of the claims.

## Claims

1. A semiconductor device comprising:
- a leadframe,
- a die attached to the leadframe using a first solder,
- a source clip and a gate clip attached to the die using a second solder, and
- a drain clip attached to the leadframe,
wherein the semiconductor device is inverted, so that the source clip and the gate clip are positioned on the bottom side of the semiconductor device,
wherein the leadframe is positioned on the top side of the semiconductor device so that the leadframe is a top exposed drain clip, and
wherein the source clip and/or the gate clip comprise a half cut locking feature.

2. A semiconductor device as claimed in claim 1, wherein the half cut locking feature is formed as a wing and located at the sides of the source clip and the gate clip.

3. A semiconductor device as claimed in claims 1 or 2, wherein the half cut locking feature is of thickness that is about 50% of thickness of the source clip and/or the gate clip.

4. A semiconductor device as claimed in claims 1 to 3, wherein the half cut locking feature, the source clip and the gate clip are made of copper.

5. A semiconductor device as claimed in any of the previous claims, wherein the drain clip comprises a dual bending.

6. A semiconductor device as claimed in claim 5, wherein the dual bended drain clip is made of copper.

7. A semiconductor device as claimed in claims 5 or 6, wherein a bending angle of the dual bending is about 90 degrees.

8. A semiconductor device as claimed in claims 5 to 7, wherein the dual bending is arranged so to prevent any mechanical tilting within the semiconductor device.

9. A semiconductor device as claimed in claims 5 to 8, wherein the dual bending is arranged so to maintain the same level for all parts of the semiconductor device, allowing both drain terminals to be exposed on top and bottom side of the package.

10. A semiconductor device as claimed in any of the previous claims, wherein the semiconductor device is a PQFN semiconductor device, or a HEMT semiconductor device, or a MOSFET semiconductor device.

11. A semiconductor device as claimed in any of the previous claims, wherein the semiconductor device further comprises two cooling systems, a first cooling system positioned on the top side on the semiconductor device and a second cooling system positioned on the bottom side of the semiconductor device.

12. A method of producing a semiconductor device, the method comprising the steps:
- creating a leadframe,
- dispensing a first solder on the top of the leadframe,
- attaching a die via the first solder to the leadframe,
- creating source, gate and drain clips,
∘ wherein the drain clip is bended and attached the respective leadframe, and
∘ wherein the source and drain clips are attached to the die,
- providing a molding,
- grinding or polishing so to expose the source, gate and drain terminals,
- singulation,
- inverting the semiconductor device, and
- mounting,
wherein the source clip and/or the drain clip comprise a half cut locking feature.

13. A method of producing a semiconductor device as claimed in claim 10, wherein the half cut locking feature is formed as a wing and located at the sides of the source clip and the gate clip.
